# DEMANDE DE BREVET EUROPEEN

(11) **EP 1 808 751 A1**
(43) Date de publication de la demande: **18.07.2007**
(21) Numéro de dépôt: 05112950.0
(22) Date de dépôt: 23.12.2005
(51) Int. Cl.: G06F 3/033

(54) **Dispositif électronique de commande à touches tactiles destiné à remplir une fonction de curseur**

(71) Demandeur: The Swatch Group Research and Development Ltd., 2074 Marin (CH)
(72) Inventeur: Rota, Sergio, 2013, Colombier (CH)
(74) Mandataire: Ravenel, Thierry Gérard Louis

(57) **Abrégé**

Le dispositif électronique de commande est destiné à remplir une fonction de curseur. Le dispositif comprend un nombre déterminé de touches tactiles de type capacitif (10) dont une plage sensible (C1, C2) au toucher de chaque touche est disposée sur une première face d'une plaque ou couche isolante du dispositif. Chaque touche peut être activée par un doigt (D) d'un utilisateur posé sur une seconde face opposée de la plaque ou de la couche en regard de ladite touche de manière à définir une valeur capacitive fonction de la position du doigt sur la touche. Le dispositif comprend également un circuit électronique de traitement des signaux de mesure fournis par les touches tactiles (10). Les plages sensibles (C1, C2) des touches tactiles sont dimensionnées et agencées pour permettre à un doigt d'un utilisateur de pouvoir activer une seule touche ou deux touches adjacentes. Un signal de mesure relatif à la valeur capacitive de chaque touche est comparé dans le circuit de traitement par rapport à un signal de référence représentatif d'une valeur capacitive de base de la touche correspondante non activée pour savoir quelle touche est activée. Ainsi, le circuit de traitement est en mesure de déterminer un nombre entier de positions du doigt sur l'ensemble des plages sensibles plus grand que le nombre de touches tactiles.

## Description

L'invention concerne un dispositif électronique de commande à touches tactiles destiné à remplir une fonction de curseur pour tout type d'instrument électronique. Le dispositif comprend un nombre déterminé de touches tactiles de type capacitif et un circuit électronique de traitement des signaux de mesure fournis par les touches. Une plage sensible au toucher de chaque touche est disposée sur une première face d'une plaque isolante du dispositif. Chaque touche peut être ainsi activée par un doigt d'un utilisateur posé sur une seconde face opposée de la plaque en regard de ladite touche. De cette manière, une valeur capacitive fonction de la position du doigt sur la touche peut être définie afin d'être traitée en tant que signal de mesure par le circuit électronique de traitement.

Le dispositif peut être intégré dans un objet portable, tel qu'une montre, un téléphone, une télécommande ou une souris d'ordinateur par exemple en liaison sans fil avec un ordinateur. Le dispositif peut également être intégré dans un objet fixe, tel qu'un appareil de cuisson, une porte d'un bâtiment, un ordinateur ou divers autres instruments électroniques pour lesquels il est nécessaire de commander certaines fonctions ou de sélectionner divers menus.

Il a déjà été proposé par le passé des dispositifs munis d'une ou plusieurs touches tactiles notamment du type capacitif afin de mesurer par exemple la position précise du doigt sur la ou les touches tactiles. On peut citer à ce titre le document US 2003/0028346 qui décrit un curseur à touches capacitives pour un ordinateur personnel. Le curseur comprend deux touches capacitives, dont la plage sensible au toucher de chaque touche est sous la forme d'un triangle rectangle. Les deux touches sont sans contact dans une direction axiale l'une en regard de l'autre pour former un rectangle. Un ou deux oscillateurs sont connectés aux touches capacitives. De ce fait, quand un doigt d'un utilisateur est placé sur les deux touches capacitives, une valeur de capacité est détectée pour chaque touche capacitive pour déterminer la position précise du doigt sur les touches. Lors d'un déplacement du doigt sur les deux touches capacitives dans une direction axiale, une variation inverse de valeur de capacité est détectée pour définir également une direction de déplacement du curseur.

Un inconvénient d'une telle solution est que le doigt doit être en contact sur les deux touches capacitives tout le long du trajet desdites touches afin de déterminer précisément une position. De plus, la précision de position du doigt sur les touches exige, pour effectuer une mesure de type analogique, un traitement de la fréquence des deux oscillateurs de manière très précise, ce qui complique la réalisation d'un tel curseur.

On peut citer également le document CH 627 615, qui décrit un dispositif d'entrée de données pour un instrument de petit volume, tel qu'une montre. Le dispositif comprend un capteur capacitif, qui est formé d'une base isolante et d'une seule plage sensible au toucher de forme triangulaire pour obtenir une variation de la valeur de capacité quand le doigt se déplace d'un sommet du triangle à sa base ou inversement. Même si une seule plage sensible est utilisée, le traitement électronique de la mesure de position est relativement compliqué pour déterminer une position précise du doigt ou son déplacement sur la touche tactile.

L'invention a donc pour but principal de fournir un dispositif électronique de commande à touches tactiles de conception simple et avec un traitement simplifié de l'information fournie par les touches tactiles afin de pallier les inconvénients de l'art antérieur cités ci-dessus.

A cet effet, l'invention concerne un dispositif électronique de commande cité ci-devant qui comprend les caractéristiques mentionnées dans la revendication 1.

Des formes d'exécution avantageuses du dispositif sont définies dans les revendications dépendantes 2 à 11.

Un avantage du dispositif électronique selon l'invention est qu'il permet de déterminer un nombre entier de positions supérieur au nombre de touches tactiles à disposition pour la commande de fonctions ou la sélection de divers menus par exemple. Le circuit de traitement est ainsi à même de détecter si le doigt d'un utilisateur est posé sur une seule touche tactile ou sur deux touches tactiles adjacentes. Pour ce faire, une comparaison dans le circuit de traitement est effectuée entre le signal de mesure représentatif de la valeur capacitive de chaque touche et un signal de référence représentatif d'une valeur capacitive de base de chaque touche non activée. Un seuil propre à chaque touche est ainsi défini à partir duquel le circuit de traitement peut déterminer si une ou deux touches adjacentes sont activées par un doigt d'un utilisateur.

Avantageusement, le nombre de positions d'un doigt sur les plages sensibles déterminées par le circuit de traitement est égal à 2N-1 pour un nombre N de touches tactiles. Le dispositif peut comprendre deux touches tactiles sous forme de L disposées tête-bêche dans une direction longitudinale afin de permettre au circuit électronique de traitement de déterminer trois positions.

Les plages sensibles des touches tactiles peuvent avantageusement être agencées les unes à la suite des autres avec une portion longitudinale de chaque plage disposée en regard et décalée dans la direction longitudinale d'une portion longitudinale d'une plage adjacente. Ceci permet de définir deux rangées de portions longitudinales. Chaque portion longitudinale d'une même rangée doit par contre être suffisamment espacée l'une de l'autre pour permettre à un doigt d'activer une seule touche ou deux touches adjacentes dans la direction longitudinale.

Dans une forme avantageuse de réalisation du dispositif, la première plage sensible et la dernière plage sensible de l'ensemble de plages sensibles ont une forme de L. La base de chaque L constitue une première position et une dernière position d'un doigt déterminées par le circuit de traitement. Les plages sensibles intermédiaires ont une forme de T et sont disposées tête-bêche les unes à la suite des autres entre la première plage et la dernière plage. Chaque barre du T constitue une portion longitudinale des plages sensibles intermédiaires.

Les buts, avantages et caractéristiques du dispositif de commande à touches tactiles apparaîtront mieux dans la description suivante en regard des dessins sur lesquels :
- les figures 1 a et 1 b représentent deux formes d'exécution de l'agencement des touches tactiles du dispositif de commande selon l'invention,
- la figure 2 représente schématiquement les différents composants électroniques d'un circuit de traitement, qui est relié aux touches tactiles du dispositif de commande selon l'invention, et
- la figure 3 représente le dispositif de commande selon l'invention intégré dans une montre pour une communication sans fil avec une station d'ordinateur.

La description suivante est relative à un dispositif électronique de commande à touches tactiles de type capacitif destiné à remplir notamment la fonction de curseur pour effectuer diverses opérations. Ce dispositif peut équiper tout instrument portable, tel qu'une montre, un téléphone portable, un organiseur, une souris d'ordinateur, ou également être monté dans un appareil électronique fixe, tel qu'un appareil de cuisson, une porte d'un bâtiment, un ordinateur ou divers autres instruments électroniques. Plusieurs composants du dispositif électronique de commande, qui sont bien connus de l'homme du métier dans ce domaine technique, ne sont relatés que de manière simplifiée.

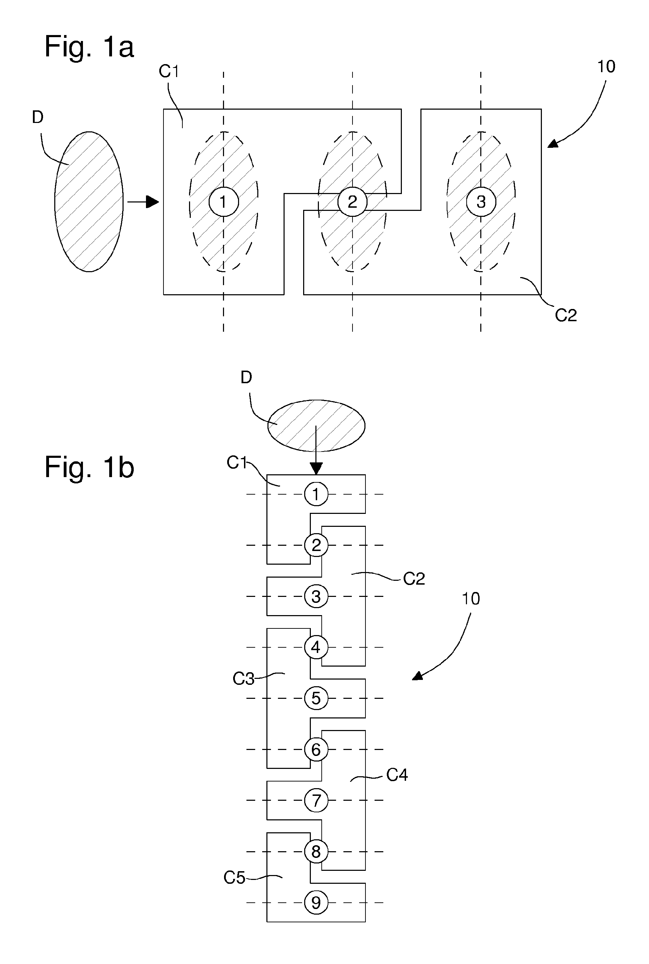

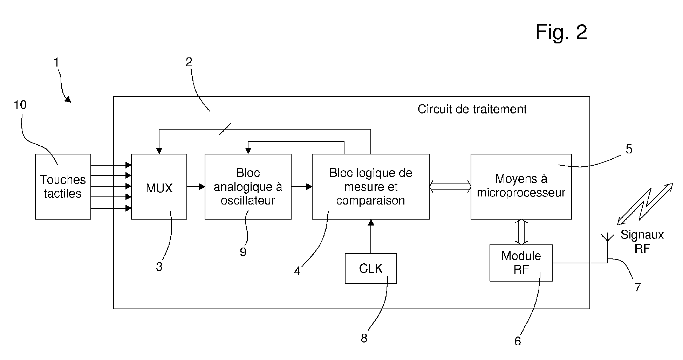

La figure 1a montre de manière simplifiée une première forme d'exécution d'un ensemble de touches tactiles 10 du dispositif électronique de commande. Les touches tactiles sont reliées à un circuit électronique de traitement du dispositif de commande décrit ci-après en référence à la figure 2. Le circuit électronique de traitement permet de traiter les signaux de mesure fournis par les touches de manière à permettre au dispositif de déterminer un nombre entier de positions d'un doigt d'un utilisateur sur les touches plus important que le nombre desdites touches. De préférence, le nombre de positions déterminées par le dispositif est égal à 2N-1 pour N touches tactiles.

Dans cette première forme d'exécution, il est utilisé deux touches tactiles C1, C2 dont la plage sensible ou électrode de chaque touche a une forme de L de dimension équivalente. Dans ce cas, le dispositif électronique est en mesure de déterminer trois positions d'un doigt sur les touches tactiles. Ces touches tactiles C1, C2 sont disposées dans une direction longitudinale, indiquée par une flèche, avec les deux plages sensibles montées tête-bêche. La dimension et l'agencement de chaque plage sensible dans la direction longitudinale doivent être définis de telle manière à permettre à un doigt d'un utilisateur d'activer facilement une seule touche tactile C1 ou C2, ou les deux touches tactiles.

Pour représenter symboliquement la dimension de chaque plage et chaque position déterminée par le circuit de traitement du dispositif, la surface moyenne de contact de l'extrémité d'un doigt D est représentée par des parties hachurées en forme d'ovale sur la figure 1 a. Lors d'un déplacement du doigt dans la direction longitudinale sur les deux touches tactiles C1 et C2, le doigt peut activer tout d'abord la touche C1 uniquement sur la base du L de la première plage sensible déterminant une première position référencée "1 ". Ensuite le doigt peut activer les deux touches C1 et C2 sur une portion intermédiaire des plages sensibles de l'ensemble des touches tactiles déterminant une seconde position référencée "2". Enfin, le doigt peut activer la touche C2 uniquement sur la base du L de la seconde plage sensible déterminant une troisième position référencée "3".

La surface de contact du doigt D sur une touche tactile modifie la valeur de la capacité, ce qui est traité par le circuit de traitement expliqué ci-après. La touche est considérée comme activée par le doigt d'un utilisateur, si sa valeur de capacité dépasse une valeur de capacité de base correspondant à la valeur de la capacité parasite de la touche initialement non activée. De ce fait en fonction de la valeur de cette capacité de base mémorisée pour chaque touche, la surface de contact du doigt peut empiéter très légèrement sur la seconde plage sensible C2 pour déterminer la première position "1 ". La seconde position "2" du doigt sur la portion intermédiaire des deux touches tactiles C1 et C2 est déterminée par le circuit de traitement si la valeur de capacité de chaque touche activée dépasse d'une certaine valeur déterminée la valeur de capacité de base de chaque touche. Pour la troisième position "3", la surface de contact du doigt D peut empiéter très légèrement sur la première plage sensible C1.

La largeur de l'ensemble des deux touches tactiles, vue dans une direction perpendiculaire à la direction longitudinale, peut être supérieure ou égale à la largeur moyenne de contact du doigt sur les touches tactiles. Cette largeur peut être comprise par exemple entre 5 mm et 15 mm, mais d'autres largeurs peuvent être définies en fonction de la taille de l'instrument dans lequel le dispositif est monté. La longueur de l'ensemble des deux touches tactiles peut être comprise par exemple entre 15 mm et 45 mm tout en permettant au doigt d'activer sans difficulté une seule touche ou les deux touches pour la détermination des trois positions. L'espace entre les deux plages sensibles ou électrodes doit être suffisant pour limiter la capacité parasite entre les deux plages. L'espace séparant les deux plages sensibles C1 et C2 peut être de l'ordre de 1 mm par exemple.

Il est à noter que chaque plage sensible peut être réalisée avec un matériau conducteur transparent, si les plages sensibles doivent être disposées sur une face intérieure d'un verre de montre par exemple. Toutefois, de simples plages sensibles métalliques peuvent également être prévues si elles sont disposées sur une face intérieure d'une plaque isolante opaque, dans le cas où le dispositif électronique équipe par exemple une souris d'ordinateur.

Il peut être prévu des moyens de guidage, non représentés, sur le verre de montre ou sur la plaque isolante pour faciliter le déplacement du doigt D dans la direction longitudinale du dispositif. Ces moyens de guidage peuvent être constitués par une creusure longitudinale sur la face extérieure de la plaque isolante, ou par une ligne en saillie. Le profil de la creusure, vu transversalement, peut être adapté à la forme du doigt. Les moyens de guidage peuvent être également constitués simplement par une indication visuelle placée dans la direction longitudinale au-dessus des touches tactiles.

Le dispositif électronique de commande permet de remplir la fonction de curseur, c'est-à-dire qu'une commande spécifique est exécutée sur chaque position du doigt sur les touches tactiles déterminée par le circuit de traitement. Diverses opérations peuvent être commandées par les touches tactiles à savoir la sélection de différents menus ou de données à visualiser sur un écran d'affichage, la commande d'exécution d'une fonction spécifique ou d'une durée de fonctionnement déterminée, la validation ou confirmation de données introduites ou d'autres opérations.

Le circuit électronique de traitement du dispositif peut être également susceptible de détecter la présence du doigt après un laps de temps déterminé sur une touche ou deux touches adjacentes de manière à valider une fonction sélectionnée ou une commande à exécuter. Le circuit de traitement peut être également susceptible de détecter une séquence de différentes positions du doigt sur des touches activées de manière à valider une fonction sélectionnée ou une commande spécifique à exécuter.

La figure 1b représente de manière simplifiée une seconde forme d'exécution d'un ensemble de touches tactiles 10 du dispositif électronique de commande. Les touches tactiles sont reliées à un circuit électronique de traitement du dispositif de commande décrit ci-après en référence à la figure 2. Toutes les caractéristiques spécifiques définies pour la première forme d'exécution sont équivalentes pour cette seconde forme d'exécution. De ce fait par simplification pour cette seconde forme d'exécution, il ne sera décrit que l'agencement des touches tactiles du dispositif.

Dans cette seconde forme d'exécution, il est utilisé cinq touches tactiles C1 à C5 agencées dans une direction longitudinale indiquée par la flèche. Avec ces cinq plages sensibles C1 à C5, le circuit électronique de traitement du dispositif est en mesure de déterminer neuf positions du doigt D sur les touches tactiles. Les différentes positions du doigt D déterminées par le circuit de traitement sont référencées de "1 " à "9". La dimension de l'ensemble de touches tactiles est représentée symboliquement par la surface moyenne de contact de l'extrémité d'un doigt D, qui est représentée par une partie hachurée en forme d'ovale sur la figure 1b.

Les plages sensibles des touches tactiles C1 à C5 sont agencées dans la direction longitudinale avec une portion longitudinale de chaque plage disposée en regard et décalée d'une portion longitudinale d'une plage adjacente. Ceci permet de définir deux rangées de portions longitudinales. Chaque portion longitudinale d'une même rangée étant suffisamment espacée l'une de l'autre pour permettre à un doigt d'activer une seule touche ou deux touches adjacentes des deux rangées dans la direction longitudinale. De ce fait, l'ensemble des touches tactiles pourrait n'être constitué que de plages sensibles de forme rectangulaire.

Cependant dans cette seconde forme d'exécution, la première plage sensible C1 et la dernière plage sensible C5 de l'ensemble de touches tactiles ont une forme de L. La base de chaque L constitue une première position "1 " et une dernière position "9" d'un doigt déterminées par le circuit de traitement. Les plages sensibles intermédiaires C2 à C4 ont par contre une forme de T. Ces plages intermédiaires sont disposées tête-bêche les unes à la suite des autres entre la première plage sensible et la dernière plage sensible. La barre de chaque T constitue une portion longitudinale des plages sensibles intermédiaires.

Bien entendu, le nombre N de touches tactiles peut être différent des deux formes d'exécution présentées tout en permettant au circuit de traitement du dispositif de déterminer un nombre 2N-1 de positions du doigt sur les touches tactiles. La forme de chaque plage sensible peut également être différente d'une forme de L ou de T ou d'une forme rectangulaire. Les touches tactiles peuvent prendre la forme de secteurs annulaires ou être de forme ovale ou polygonale.

Le dispositif électronique de commande 1 est expliqué ci-après en référence à la figure 2. Le dispositif électronique de commande comprend principalement l'ensemble de touches tactiles ou capteurs capacitifs 10, qui est relié à un circuit de traitement 2 des signaux de mesure fournis par les touches tactiles. Comme le circuit de traitement se base en partie sur une forme d'exécution décrite en référence à la figure 5 dans le document EP 1 324 162 du même Demandeur, qui est incorporé ici par référence, il sera décrit de manière simplifiée.

Le circuit électronique de traitement 2 comprend tout d'abord un multiplexeur 3, à l'entrée duquel sont connectées toutes les touches tactiles, dont chaque plage sensible constitue une première électrode d'un condensateur, un bloc analogique à oscillateur 9 et un bloc logique de mesure et de comparaison 4. Le bloc analogique 9 comprend un oscillateur commandé en tension, qui est connecté à la sortie du multiplexeur 3. Le multiplexeur a pour tâche de connecter successivement et périodiquement chaque touche tactile à l'entrée de l'oscillateur en fonction de mots binaires de commande fournis par le bloc logique de mesure et de comparaison 4.

Comme l'oscillateur est de préférence un oscillateur du type RC, la valeur capacitive de chaque plage sensible des touches tactiles branchée à l'oscillateur va servir à déterminer une fréquence d'oscillation. Cette fréquence est donc proportionnelle à l'inverse de la valeur de la capacité totale. Ainsi, sans l'action d'un doigt sur une des touches tactiles 10 branchée à l'oscillateur, la fréquence de l'oscillateur n'est déterminée qu'en fonction de la valeur capacitive d'un condensateur parasite de chaque touche. Par contre quand un doigt active une des touches tactiles branchée à l'oscillateur, la valeur capacitive de cette touche est plus importante que celle uniquement du condensateur parasite. Cela a pour conséquence de diminuer la fréquence de l'oscillateur pour définir un signal de mesure relatif à la valeur capacitive de la touche activée. Une comparaison de ce signal de mesure avec un signal de référence représentatif d'une valeur capacitive de base correspondant à la valeur de la capacité parasite de ladite touche initialement non activée est donc effectuée dans le bloc logique 4. Une fonction spécifique est exécutée si la valeur capacitive de la touche activée ou de chacune de deux touches adjacentes activées est plus grande que leur valeur capacitive de base. Ainsi grâce à l'agencement des touches tactiles décrites ci-dessus, le bloc logique 4 est en mesure de déterminer un certain nombre de positions du doigt sur lesdites touches tactiles 10.

Le signal de mesure de chaque touche traité dans le bloc logique est obtenu à l'aide d'un compteur d'impulsions chargé de compter le nombre d'impulsions d'un signal de sortie d'une bascule de l'oscillateur dans une fenêtre temporelle de comptage. Cette fenêtre de comptage est définie par un signal d'horloge CLK, qui peut être fourni par un diviseur de fréquence 8 de l'oscillateur d'un circuit garde-temps. L'oscillateur du circuit garde-temps peut avoir un signal de fréquence proche de 30 kHz, alors que le signal d'horloge CLK peut avoir une fréquence divisée proche de 125 Hz. Pour chaque touche, le nombre binaire compté d'impulsions, par exemple défini sur 8 bits, va servir au bloc logique de mesure pour une comparaison avec un nombre binaire seuil mémorisé définissant le signal de référence représentatif de la valeur capacitive de base de ladite touche. A chaque mise en fonction du dispositif, un nombre seuil est donc mémorisé pour chaque touche initialement non activée dans le bloc logique 4 ou des moyens à microprocesseur 5. Le nombre seuil peut être différent d'une touche à l'autre étant donné la dispersion de chaque valeur capacitive de la capacité parasite.

Dans un mode de fonctionnement normal, le bloc logique va transmettre des données binaires par bus de données à des moyens à microprocesseur 5. Les moyens à microprocesseur vont opérer une reconnaissance de la position du doigt sur les touches tactiles déterminées par le bloc logique 4 de manière à gérer l'exécution d'une commande ou d'une fonction à exécuter. Les moyens à microprocesseur 5 sont également susceptibles de lire des informations stockées dans des registres non représentés du bloc logique de mesure 4, ou d'envoyer des paramètres de configuration audit bloc logique. Le signal de référence relatif à la valeur capacitive de base de chaque touche est par exemple stocké dans des registres du bloc logique pour être lu par les moyens à microprocesseur.

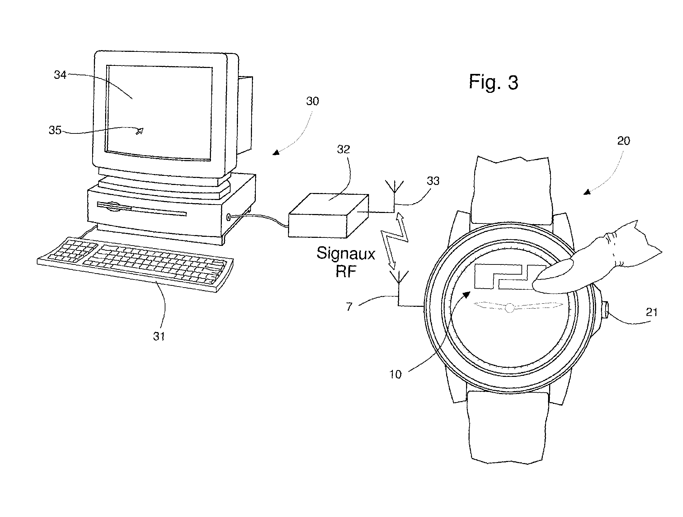

Les moyens à microprocesseur 5 sont reliés également par un bus de données à un module RF 6 pour gérer la réception ou la transmission de signaux RF de commandes ou de données par une antenne 7 du module RF 6. Des signaux RF de commandes peuvent être transmis par exemple par l'antenne 7 du module à destination d'un appareil muni également de moyens de réception et/ou d'émission de signaux RF. L'appareil électronique peut par exemple être une station d'ordinateur comme expliqué ci-dessous en référence à la figure 3. Le module RF 6 du dispositif 1 peut également recevoir par l'antenne 7 des signaux RF de données pour programmer des fonctions à exécuter par l'activation des touches tactiles 10. La fréquence des signaux RF peut être choisie par exemple à une valeur de l'ordre de 433,9 MHz, mais elle pourrait également être inférieure, telle que 125 kHz, ou supérieure. Bien entendu, comme le module RF est fort consommateur en énergie électrique, le dispositif électronique de commande peut être enclenché par l'action d'un bouton poussoir de l'instrument, tel qu'une montre le comprenant.

La figure 3 représente un instrument portable, tel qu'une montre-bracelet 20, qui comprend le dispositif électronique de commande à touches tactiles 10 susceptible de communiquer des données ou des commandes par des signaux RF avec une station d'ordinateur 30. Pour ce faire, la station d'ordinateur 30 est composée pour l'essentiel d'un clavier 31, d'un écran 34, et d'un boîtier périphérique 32, qui est relié par un câble du type USB ou autre à une entrée de la station d'ordinateur. Ce boîtier 32 comprend des moyens d'émission et/ou de réception de signaux radiofréquences courte distance par une antenne 33 pour la station d'ordinateur 30. Il est bien clair que ces moyens d'émission et/ou de réception de la station d'ordinateur, dans une variante d'exécution, peuvent être également intégrés dans la partie principale de ladite station.

La montre 20 comprend également des moyens d'émission et/ou de réception de signaux radiofréquences RF courte distance par une antenne 7, qui sont constitués par le module RF du dispositif électronique de commande, ainsi qu'un bouton-poussoir 21 pour mettre en fonction le dispositif électronique. Dès que la station d'ordinateur est enclenchée, les touches tactiles 10 du dispositif en fonction peuvent être activées par un doigt d'un utilisateur selon une des positions déterminées par le circuit de traitement pour l'exécution d'une commande ou d'une fonction spécifique. Cette commande ou fonction spécifique est transmise du dispositif électronique de la montre 20 à destination de la station d'ordinateur par exemple pour effectuer un déplacement d'un curseur informatique 35 ou valider une commande ou des données introduites.

Sur cette figure 3, le dispositif électronique de commande ne comprend que deux touches tactiles 10 agencées comme la première forme d'exécution décrite ci-dessus. La plage sensible transparente de chaque touche est disposée sur une face intérieure du verre de montre. Bien entendu, il peut être envisagé un plus grand nombre de touches tactiles, ainsi qu'un autre agencement desdites touches tactiles pour remplir notamment la fonction de curseur selon l'invention.

A partir de la description qui vient d'être faite, de multiples variantes du dispositif électronique de commande à touches tactiles peuvent être conçues par l'homme du métier sans sortir du cadre de l'invention définie par les revendications. Les touches tactiles peuvent être activées par un doigt d'un utilisateur posé directement sur une couche isolante de protection des touches. Dans ce cas, chaque touche tactile peut être visible pour faciliter l'utilisation du dispositif électronique. Un condensateur de référence peut être branché à l'entrée du multiplexeur de manière à obtenir un unique signal de référence. Le nombre binaire mémorisé de ce signal de référence peut être ainsi comparé successivement à chaque nombre binaire de chaque touche.

## Revendications

1. Dispositif électronique de commande (1) destiné à remplir une fonction de curseur, le dispositif comprenant un nombre déterminé de touches tactiles de type capacitif (10) dont une plage sensible (C1 à C5) au toucher de chaque touche est disposée sur une première face d'une plaque ou couche isolante du dispositif, chaque touche pouvant être activée par un doigt (D) d'un utilisateur posé sur une seconde face opposée de la plaque ou de la couche en regard de ladite touche de manière à définir une valeur capacitive fonction de la position du doigt sur la touche, et un circuit électronique de traitement (2) des signaux de mesure fournis par les touches, **caractérisé en ce que** les plages sensibles (C1 à C5) des touches tactiles sont dimensionnées et agencées pour permettre à un doigt d'un utilisateur de pouvoir activer une seule touche ou deux touches adjacentes, un signal de mesure relatif à la valeur capacitive de chaque touche étant comparé dans le circuit de traitement par rapport à au moins un signal de référence seuil pour savoir quelle touche est activée, afin que ledit circuit de traitement soit en mesure de déterminer un nombre entier de positions du doigt sur l'ensemble des plages sensibles plus grand que le nombre de touches tactiles.

2. Dispositif électronique (1) selon la revendication 1, **caractérisé en ce que** les plages sensibles des touches tactiles sont agencées dans une direction longitudinale, et **en ce que** le nombre de positions du doigt sur les plages sensibles déterminées par le circuit de traitement est égal à 2N-1 pour N touches tactiles.

3. Dispositif électronique (1) selon l'une des revendications 1 et 2, **caractérisé en ce qu'**il comprend deux touches tactiles, dont les plages sensibles (C1, C2) ont chacune une forme de L et sont disposées tête-bêche l'une en regard de l'autre dans la direction longitudinale pour définir un ensemble de touches (10) de forme générale rectangulaire, la base du L de chaque touche définissant une extrémité de l'ensemble de touches tactiles de manière que l'extrémité d'un doigt posé sur une des bases n'active qu'une seule touche correspondante, alors que l'extrémité du doigt posé sur une portion intermédiaire de l'ensemble des touches active les deux touches pour permettre au circuit de traitement de déterminer trois positions du doigt sur les touches.

4. Dispositif électronique (1) selon l'une des revendications 1 et 2, **caractérisé en ce que** les plages sensibles (C1 à C5) des touches tactiles sont agencées dans une direction longitudinale avec une portion longitudinale de chaque plage disposée en regard et décalée dans la direction longitudinale d'une portion longitudinale d'une plage adjacente pour définir deux rangées de portions longitudinales, chaque portion longitudinale d'une même rangée étant suffisamment espacée l'une de l'autre pour permettre à un doigt d'activer une seule touche ou deux touches adjacentes dans la direction longitudinale.

5. Dispositif électronique (1) selon la revendication 4, **caractérisé en ce que** la première plage sensible (C1) et la dernière plage sensible (C5) de l'ensemble de plages sensibles ont une forme de L, dont la base de chaque L constitue une première position et une dernière position d'un doigt déterminées par le circuit de traitement, les plages sensibles intermédiaires (C2 à C4) ayant une forme de T en étant disposées tête-bêche les unes à la suite des autres entre la première et dernière plages sensibles, chaque barre du T constituant une portion longitudinale des plages sensibles intermédiaires.

6. Dispositif électronique (1) selon l'une des revendications précédentes, **caractérisé en ce que** la largeur de l'ensemble des plages sensibles disposées dans la direction longitudinale est dimensionnée supérieure ou égale à la largeur moyenne de contact (D) de l'extrémité d'un doigt posé sur les touches tactiles, et **en ce qu'**un signal de référence seuil représentatif d'une valeur capacitive de base est mémorisé pour chaque touche initialement non activée dans le circuit électronique de traitement de manière à pouvoir être comparé respectivement à chaque signal de mesure relatif à la valeur capacitive de la touche correspondante.

7. Dispositif électronique (1) selon l'une des revendications précédentes, **caractérisé en ce que** la plaque isolante comprend des moyens de guidage pour guider le doigt dans une direction longitudinale en regard des touches tactiles.

8. Dispositif électronique (1) selon la revendication 7, **caractérisé en ce que** les moyens de guidage sont constitués par une creusure longitudinale sur la seconde face de la plaque isolante.

9. Dispositif électronique (1) selon la revendication 7, **caractérisé en ce que** les moyens de guidage sont constitués par une indication visuelle placée dans la direction longitudinale au-dessus des touches tactiles.

10. Dispositif électronique (1) selon l'une des revendications précédentes, **caractérisé en ce que** le circuit de traitement (2) est susceptible de détecter la présence du doigt après un laps de temps déterminé sur une touche ou deux touches adjacentes pour valider une fonction sélectionnée ou une commande à exécuter.

11. Dispositif électronique (1) selon l'une des revendications 1 à 9, **caractérisé en ce que** le circuit de traitement (2) est susceptible de détecter une séquence de différentes positions du doigt sur des touches activées pour valider une fonction sélectionnée ou une commande spécifique à exécuter.
